# EUROPEAN PATENT APPLICATION

(11) **EP 4 620 986 A1**
(43) Date of publication of application: **24.09.2025**
(21) Application number: 23891313.1
(22) Date of filing: 26.10.2023
(51) Int. Cl.: C08F 220/18, C09D 133/14, C09D 201/00

(54) **RANDOM COPOLYMER, COATING COMPOSITION AND RESIST COMPOSITION CONTAINING SAID COPOLYMER**

(30) Priority: 14.11.2022 JP 2022181571
(71) Applicant: DIC Corporation, Tokyo 174-8520 (JP)
(72) Inventor: SASAMOTO Shin, Ichihara-shi, Chiba 290-8585 (JP); HATASE Masaki, Ichihara-shi, Chiba 290-8585 (JP); UENO Junpei, Ichihara-shi, Chiba 290-8585 (JP); SHIMIZU Ryohei, Ichihara-shi, Chiba 290-8585 (JP); SUZUKI Hideya, Ichihara-shi, Chiba 290-8585 (JP)
(74) Representative: TBK
(86) International application number: PCT/JP2023/038625
(87) International publication number: WO 2024/106158

(57) **Abstract**

Provided is a copolymer that functions as a silicone-based leveling agent having leveling properties and recoatability. Specifically, a random copolymer including: a structural unit A derived from a polymerizable monomer (a1) having a functional group represented by -Si[OSi(R)₃]ₙ[R']₃₋ₙ and a (meth)acryloyl group; and a structural unit B derived from a polymerizable monomer (a2) having one or more selected from the group consisting of an alkyl group having from 1 to 18 carbon atoms, an aromatic groups having from 6 to 18 carbon atoms, and a group containing a polyoxyalkylene chain, wherein the random copolymer contains the structural unit A in an amount of from 50 to 80 mass% with respect to a total of the structural units A and B, and the random copolymer has the weight average molecular weight (Mw) of 10000 or more.

## Description

### TECHNICAL FIELD

The present invention relates to a random copolymer, and a coating composition and a resist composition containing the copolymer.

### BACKGROUND ART

A leveling agent is added in order to smooth a coating film that is prepared by applying a coating composition such as a coating material composition or a resist composition. Specifically, when a leveling agent is added to a coating composition, the leveling agent is oriented on the surface of the coating film and reduces the surface tension of the coating film, whereby an effect of smoothing the resulting coating film is provided. The occurrence of cissing and heterogeneity can be reduced on the coating film with a smooth surface.

A leveling agent is used, for example, in automotive coating materials, and a coating material composition containing a leveling agent can impart a high smoothness to the surface of the resulting coating film and can impart gloss to the appearance of automobiles.

As a leveling agent used for automotive coating materials, a silicone-based leveling agent has been proposed (Patent Document 1).

The leveling agent has a wide range of applications and also is used in a color resist composition that is used for fabrication of a color filter to be used in liquid crystal displays, for example. The production of a color filter generally includes steps of: applying a color resist composition onto a glass substrate by a coating method such as spin coating or slit coating; exposing a dried coating film to light using a mask; and then developing the film to form a colored pattern. During this production, color heterogeneity of pixels is liable to occur when the smoothness of the coating film is not good and there is heterogeneity in film thickness, or when there is heterogeneity in application, cissing, or the like. When a leveling agent is added to the color resist composition, the resulting coating film can be improved in smoothness, whereby the surfaces of red (R), green (G), and blue (B) pixels and the surfaces of black matrices (BM) formed between these pixels can exhibit a high smoothness, and therefore a color filter with less color heterogeneity can be provided.

Patent Document 1 describes a silicone-based leveling agent that is synthesized by free radical polymerization. However, unfortunately, the silicone content in the leveling agent actually evaluated is low, and a sufficiently smooth coating film cannot be prepared.

Moreover, Patent Document 2 describes a silicone-based leveling agent that is synthesized by living polymerization and has good leveling properties. However, it has a block structure and hence the coating film has high liquid repellency, consequently there is an issue of poor overcoatability (recoatability).

### CITATION LIST

### PATENT DOCUMENT

Patent Document 1: JP 2003-226834 A
Patent Document 2: WO 2021/131726

### SUMMARY OF INVENTION

### TECHNICAL PROBLEM

An object of the present invention is to provide a copolymer that functions as a silicone-based leveling agent having leveling properties and recoatability.

### SOLUTION TO PROBLEM

As a result of intensive studies to solve the above-mentioned issues, the present inventors have found that both leveling properties and recoatability can be achieved by a leveling agent containing a random copolymer produced by reacting a polymerizable monomer (a1) having a functional group represented by -Si[OSi(R)₃]ₙ[R']₃₋ₙ and a (meth)acryloyl group with a polymerizable monomer (a2) having one or more selected from the group consisting of an alkyl group having from 1 to 18 carbon atoms, an aromatic group having from 6 to 18 carbon atoms, and a group containing a polyoxyalkylene chain, and thereby having completed the present invention.

That is, the present invention relates to a random copolymer including a structural unit A derived from a polymerizable monomer (a1) having a functional group represented by -Si[OSi(R)₃]ₙ[R']₃₋ₙ (where n is an integer of from 1 to 3, each R independently represents an alkyl group having from 1 to 3 carbon atoms, and each R' independently represents an alkyl group having from 1 to 3 carbon atoms) and a (meth)acryloyl group;
a structural unit B derived from a polymerizable monomer (a2) having one or more selected from the group consisting of an alkyl group having from 1 to 18 carbon atoms, an aromatic group having from 6 to 18 carbon atoms, and a group containing a polyoxyalkylene chain,
wherein
the random copolymer contains the structural unit A in an amount of from 50 to 80 mass% with respect to a total of the structural units A and B, and
the random copolymer has a weight average molecular weight (Mw) of 10000 or more.

The present invention also relates to a coating composition containing the random copolymer.

The present invention also relates to a resist composition containing the random copolymer.

The present invention also relates to an article containing the random copolymer.

The present invention also relates to a method for producing a random copolymer, the method including free radical polymerization in which a compound represented by formula (a1-1), and any one or more of a compound represented by (a2-1) and a compound represented by formula (a2-2) are used as reaction raw materials: 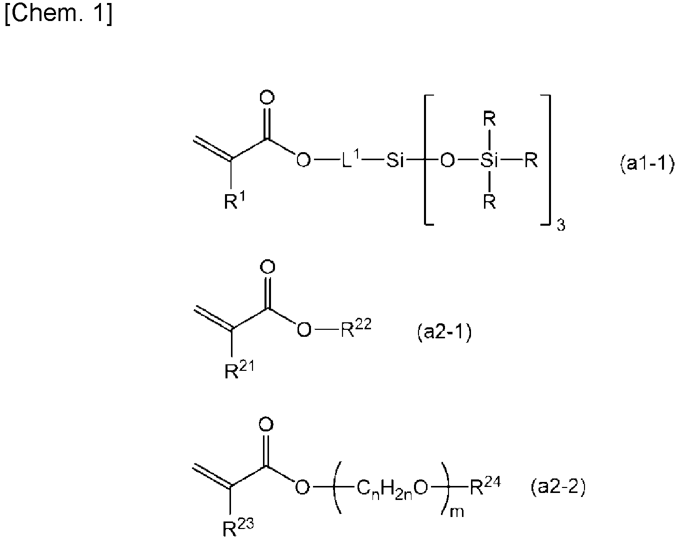 (where
each R independently represents an alkyl group having from 1 to 3 carbon atoms,
R¹ is a hydrogen atom or a methyl group,
L¹ is a divalent organic group or a single bond,
R²¹ is a hydrogen atom or a methyl group,
R²² is an alkyl group having from 1 to 18 carbon atoms,
R²³ is a hydrogen atom or a methyl group,
R²⁴ is a hydrogen atom or an alkyl group having from 1 to 18 carbon atoms,
n is an integer in a range of from 1 to 4, and m is an integer in a range of from 1 to 200.

### ADVANTAGEOUS EFFECTS OF INVENTION

According to the present invention, it is possible to provide a copolymer that functions as a silicone-based leveling agent having leveling properties and recoatability.

### DESCRIPTION OF EMBODIMENTS

Hereinafter, embodiments for carrying out the present invention will be described.

Note that, as used herein, the wording "x to y" represents a numerical range of "x or more and y or less". The upper and lower limits stated for numerical ranges can be combined in any way.

In addition, an embodiment in which two or more individual embodiments of the present invention described below are combined is also an embodiment of the present invention.

Moreover, as used herein, the term "(meth)acrylate" refers to one or both of acrylate and methacrylate.

The random copolymer according to an embodiment of the present invention includes: a structural unit A derived from a polymerizable monomer (a1) having a functional group represented by -Si[OSi(R)₃]ₙ[R']₃₋ₙ (where n is an integer of from 1 to 3, each R independently represents an alkyl group having from 1 to 3 carbon atoms, and each R' independently represents an alkyl group having from 1 to 3 carbon atoms) and an acryloyl group; and a structural unit B derived from a polymerizable monomer (a2) having one or more selected from the group consisting of an alkyl group having from 1 to 18 carbon atoms, an aromatic group having from 6 to 18 carbon atoms, and a group containing a polyoxyalkylene chain.

The content of the structural unit A is from 50 to 80 mass% with respect to a total of the structural units A and B, and the weight average molecular weight (Mw) is 10000 or more.

In the random copolymer of the present invention, the content of the structural unit A is from 50 to 80 mass%, and the functional group represented by -Si[OSi(R)₃]ₙ[R']₃₋ₙ is randomly disposed in the polymer chain, whereby both leveling properties and recoatability can be achieved.

The random copolymer of the present invention can be polymerized, for example, by free radical polymerization of the above-described polymerizable monomer (a1) and polymerizable monomer (a2).

Hereinafter, each of the polymerizable monomer (a1) and the polymerizable monomer (a2) constituting the random copolymer of the present invention will be described.

In the polymerizable monomer (a1), the functional group represented by -Si[OSi(R)₃]ₙ[R']₃₋ₙ is preferably a functional group represented by - Si[OSi(R)₃]₃, and more preferably -Si[OSi(CH₃)₃]₃. When the functional group represented by -Si[OSi(R)₃]ₙ[R']₃₋ₙ is -Si[OSi(CH₃)₃]₃, the copolymer of the present invention can have a high surface segregation ability.

In the present invention, the term "polymerizable monomer" means a compound having a polymerizable unsaturated group, and the polymerizable unsaturated group included in the polymerizable monomer (a1) is only needed to be a group containing a vinyl group, and examples thereof include a (meth)acryloyl group, a (meth)acryloyloxy group, a (meth)acryloylamide group, a vinyl ether group, an allyl group, a styryl group, and a maleimide group. Among them, a (meth)acryloyl group or a (meth)acryloyloxy group is preferable.

The polymerizable monomer (a1) is preferably a compound represented by the following formula (a1-1). 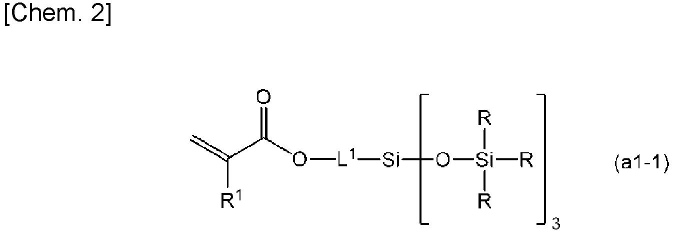 (In the formula (a1-1),
each R independently represents an alkyl group having from 1 to 3 carbon atoms.
R¹ is a hydrogen atom or a methyl group.
L¹ is a divalent organic group or a single bond.)

The divalent organic group of L¹ is preferably an alkylene group having from 1 to 50 carbon atoms, or an alkyleneoxy group having from 1 to 50 carbon atoms.

Examples of the alkylene group having from 1 to 50 carbon atoms in L¹ include a methylene group, an ethylene group, an n-propylene group, an n-butylene group, an n-pentylene group, an n-hexylene group, an n-heptylene group, an n-octylene group, an n-nonylene group, an n-decylene group, an n-dodecylene group, an isopropylene group, a 2-methylpropylene group, a 2-methylhexylene group, and a tetramethylethylene group.

The alkylene group having from 1 to 50 carbon atoms in L¹ is preferably an alkylene group having from 1 to 15 carbon atoms, more preferably an alkylene group having from 1 to 5 carbon atoms, and still more preferably a methylene group, an ethylene group, a n-propylene group, or an isopropylene group.

The alkyleneoxy group having from 1 to 50 carbon atoms in L¹ is, for example, a group in which one or more -CH₂- in the alkylene group are substituted with -O-.

The alkyleneoxy group having from 1 to 50 carbon atoms in L¹ is preferably an alkyleneoxy group having from 1 to 15 carbon atoms, more preferably an alkyleneoxy group having from 1 to 8 carbon atoms, and still more preferably a methyleneoxy group, an ethyleneoxy group, a propyleneoxy group, an oxytrimethylene group, a butyleneoxy group, an oxytetramethylene group, a pentyleneoxy group, a heptyleneoxy group or an octyleneoxy group.

When the divalent organic group in L¹ is an alkylene group having from 1 to 50 carbon atoms or an alkyleneoxy group having from 1 to 50 carbon atoms, in these divalent organic groups, some -CH₂- may be replaced with a carbonyl group (-C(=O)-) or a phenylene group, and a hydroxyl group or the like may be substituted on a carbon atom.

The functional group represented by -Si[OSi(R)₃]₃ in the compound represented by the formula (a1-1) is preferably -Si[OSi(CH₃)₃]₃, and the compound is represented by the following formula (a1-2). 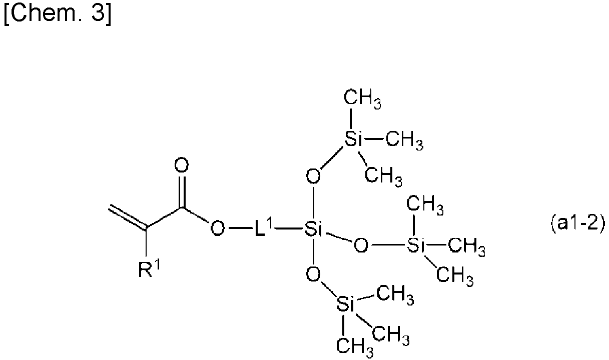 (In the formula (a1-2), R¹ is a hydrogen atom or a methyl group, and L¹ is a divalent organic group or a single bond.)

The copolymer of the present invention may contain a structural unit A derived from two or more types of polymerizable monomers (a1) whose structures differ from each other. The polymerizable monomer (a1) is preferably a single type polymerizable monomer.

The polymerizable monomer (a1) can be produced by a known method, and a commercially available product thereof may be used.

As the commercially available product of the polymerizable monomer (a1), for example, 3-(methacryloyloxy)propyltris(trimethylsiloxy) silane is commercially available.

In the copolymer of the present invention, the content of the structural unit A is 50 mass% or more, preferably 60 mass% or more, and more preferably 65 mass% or more with respect to the total of the structural units A and B. In addition, the content is 80 mass% or less, preferably 75 mass% or less.

The content of the structural unit A can be adjusted by the raw material feed ratio of the polymerizable monomer (a1) in producing the copolymer of the present invention.

The content of the functional group represented by -Si[OSi(R)₃]ₙ[R']₃₋ₙ in the copolymer of the present invention is, for example, in a range of more than 30 mass% and 60 mass% or less, preferably in a range of from 40 to 60 mass%, and more preferably in a range of from 50 to 60 mass%, with respect to a total amount of the copolymer.

The content of the functional group represented by -Si[OSi(R)₃]ₙ[R']₃₋ₙ can be adjusted by the raw material feed ratio of the polymerizable monomer (a1) in producing the copolymer of the present invention.

The polymerizable monomer (a2) is a polymerizable monomer having one or more selected from the group consisting of an alkyl group having from 1 to 18 carbon atoms, an aromatic group having from 6 to 18 carbon atoms, and a group containing a polyoxyalkylene chain.

The polymerizable unsaturated group included in the polymerizable monomer (a2) is only needed to be a group that contains a vinyl group, and examples thereof include a (meth)acryloyl group, a (meth)acryloyloxy group, a (meth)acryloylamide group, a vinyl ether group, an allyl group, a styryl group, and a maleimide group. Among them, a (meth)acryloyl group or a (meth)acryloyloxy group is preferable.

The alkyl group having from 1 to 18 carbon atoms included in the polymerizable monomer (a2) may be any of a linear alkyl group, a branched alkyl group, or a cyclic alkyl group, and specific examples thereof include a methyl group, an ethyl group, a normal propyl group, an isopropyl group, an n-butyl group, a t-butyl group, an n-hexyl group, a cyclohexyl group, an n-octyl group, and a hexadecyl group.

The alkyl group having from 1 to 18 carbon atoms included in the polymerizable monomer (a2) is preferably an alkyl group having from 1 to 6 carbon atoms.

Examples of the aromatic group having from 6 to 18 carbon atoms included in the polymerizable monomer (a2) include a phenyl group, a naphthyl group, an anthracene-1-yl group, and a phenanthrene-1-yl group.

The group containing a (poly)oxyalkylene chain included in the polymerizable monomer (a2) is a monovalent group containing a repeating moiety of oxyalkylene or a divalent linking group containing a repeating moiety of oxyalkylene.

When the polymerizable unsaturated group of the polymerizable monomer (a2) is a (meth)acryloyl group, the polymerizable monomer having a group containing a (poly)oxyalkylene chain is, for example, a compound represented by the following general formula (a2-poa1) or (a2-poa2). 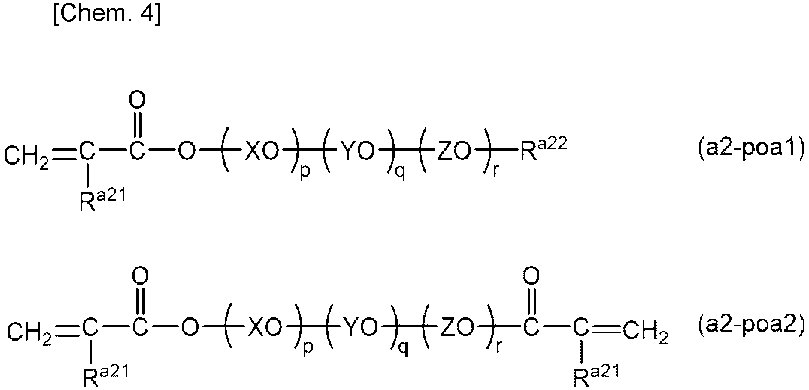 (In the formulae (a2-poa1) and (a2-poa2),
each R^{a21} independently represents a hydrogen atom or a methyl group.
R^{a22} is a hydrogen atom or an alkyl group having from 1 to 18 carbon atoms.
p is an integer of 0 or more, q is an integer of 0 or more, r is an integer of 0 or more, and p + q + r is an integer of 1 or more.
X, Y, and Z are each independently an alkylene group having from 1 to 6 carbon atoms.

In the formulae (a2-poa1) and (a2-poa2) set forth above, a group represented by -(XO)ₚ-(YO)_{q}-(ZO)ᵣ-R^{a22} and a group represented by -(XO)ₚ-(YO)_{q}-(ZO)ᵣ- correspond to a group containing a (poly)oxyalkylene chain.

In the formulae (a2-poa1) and (a2-poa2) set forth above, the alkylene group having from 1 to 6 carbon atoms in X, Y, and Z is preferably an alkylene group having from 2 to 4 carbon atoms.

Examples of the polymerizable monomer (a2) that includes an alkyl group having from 1 to 18 carbon atoms and whose polymerizable unsaturated group is a (meth)acryloyl group include: alkyl esters having from 1 to 18 carbon atoms of (meth)acrylic acid, such as methyl (meth)acrylate, ethyl (meth)acrylate, n-propyl (meth)acrylate, isopropyl (meth)acrylate, n-butyl (meth)acrylate, s-butyl (meth)acrylate, isobutyl (meth)acrylate, t-butyl (meth)acrylate, n-pentyl (meth)acrylate, n-hexyl (meth)acrylate, n-heptyl (meth)acrylate, n-octyl (meth)acrylate, 2-ethylhexyl (meth)acrylate, decyl (meth)acrylate, dodecyl (meth)acrylate, stearyl (meth)acrylate, and isostearyl (meth)acrylate; and bridged cyclic alkyl esters having from 1 to 18 carbon atoms of (meth)acrylic acid, such as dicyclopentanyloxylethyl (meth)acrylate, isobornyloxylethyl (meth)acrylate, isobornyl (meth)acrylate, adamantyl (meth)acrylate, dimethyladamantyl (meth)acrylate, dicyclopentanyl (meth)acrylate, and dicyclopentenyl (meth)acrylate.

Examples of the polymerizable monomer (a2) that includes a phenylalkyl group having from 7 to 18 carbon atoms or a phenoxyalkyl group having from 7 to 18 carbon atoms and whose polymerizable unsaturated group is a (meth)acryloyl group include benzyl (meth)acrylate, 2-phenoxymethyl (meth)acrylate, and 2-phenoxyethyl (meth)acrylate.

Examples of the polymerizable monomer (a2) that has an alkyl group having from 1 to 18 carbon atoms and whose polymerizable unsaturated group is a vinyl ether group include: alkyl vinyl ethers such as methyl vinyl ether, ethyl vinyl ether, n-propyl vinyl ether, isopropyl vinyl ether, n-butyl vinyl ether, isobutyl vinyl ether, tert-butyl vinyl ether, n-pentyl vinyl ether, n-hexyl vinyl ether, n-octyl vinyl ether, n-dodecyl vinyl ether, 2-ethylhexyl vinyl ether, and cyclohexyl vinyl ether; and cycloalkyl vinyl ether.

Examples of the polymerizable monomer (a2) including an aromatic group having from 6 to 18 carbon atoms include styrene, α-methylstyrene, p-methylstyrene, and p-methoxystyrene.

Examples of the polymerizable monomer (a2) that has an alkyl group having from 1 to 18 carbon atoms and whose polymerizable unsaturated group is a (meth)acryloylamide group include N,N-dimethylacrylamide, N,N-diethylacrylamide, N-isopropylacrylamide, diacetone acrylamide, and acryloyl morpholine.

Examples of the polymerizable monomer (a2) that includes an alkyl group having from 1 to 18 carbon atoms and whose polymerizable unsaturated group is a maleimide group include methylmaleimide, ethylmaleimide, propylmaleimide, butylmaleimide, hexylmaleimide, octylmaleimide, dodecylmaleimide, stearylmaleimide, and cyclohexylmaleimide.

Examples of the polymerizable monomer (a2) that has a group including a polyoxyalkylene chain and whose polymerizable unsaturated group is a (meth)acryloyl group include polypropylene glycol mono(meth)acrylate, polyethylene glycol mono(meth)acrylate, polytrimethylene glycol mono(meth)acrylate, polytetramethylene glycol mono(meth)acrylate, poly(ethylene glycol/propylene glycol) mono(meth)acrylate, polyethylene glycol/polypropylene glycol mono(meth)acrylate, poly(ethylene glycol/tetramethylene glycol) mono(meth)acrylate, polyethylene glycol/polytetramethylene glycol mono(meth)acrylate, poly(propylene glycol/tetramethylene glycol) mono(meth)acrylate, polypropylene glycol/polytetramethylene glycol mono(meth)acrylate, poly(propylene glycol/1,2-butylene glycol) mono(meth)acrylate, polypropylene glycol/poly(1,2-butylene glycol) mono(meth)acrylate, poly(ethylene glycol/1,2-butylene glycol) mono(meth)acrylate, polyethylene glycol/poly(1,2-butylene glycol) mono(meth)acrylate, poly(tetraethylene glycol/1,2-butylene glycol) mono(meth)acrylate, polytetraethylene glycol/poly(1,2-butylene glycol) mono(meth)acrylate, poly(1,2-butylene glycol) mono(meth)acrylate, poly(ethylene glycol/trimethylene glycol) mono(meth)acrylate, poly(ethylene glycol/trimethylene glycol) mono(meth)acrylate, polyethylene glycol/polytrimethylene glycol mono(meth)acrylate, poly(propylene glycol/trimethylene glycol) mono(meth)acrylate, polypropylene glycol/polytrimethylene glycol mono(meth)acrylate, poly(trimethylene glycol/tetramethylene glycol) mono(meth)acrylate, polytrimethylene glycol/polytetramethylene glycol mono(meth)acrylate, poly(1,2-butylene glycol/trimethylene glycol) mono(meth)acrylate, poly(1,2-butylene glycol/polytrimethylene glycol) mono(meth)acrylate, 2-hydroxyethyl (meth)acrylate, 2-hydroxypropyl (meth)acrylate, 2-hydroxybutyl (meth)acrylate, 4-hydroxybutyl (meth)acrylate, poly(1,2-butylene glycol/tetramethylene glycol) mono(meth)acrylate, and poly(1,2-butylene glycol/polytetramethylene glycol) mono(meth)acrylate.

Note that, the term "poly(ethylene glycol/propylene glycol)" means a random copolymer of ethylene glycol and propylene glycol, and the term "polyethylene glycol/polypropylene glycol" means a block copolymer of ethylene glycol and propylene glycol.

The polymerizable monomer (a2) is preferably one or more selected from the group consisting of a compound represented by the following formula (a2-1), a compound represented by the following formula (a2-2), and a compound represented by the following formula (a2-3), and more preferably one or more selected from the group consisting of a compound represented by the following formula (a2-1) and a compound represented by the following formula (a2-2). These compounds can exhibit high miscibility when the copolymer of the present invention is used as a leveling agent. 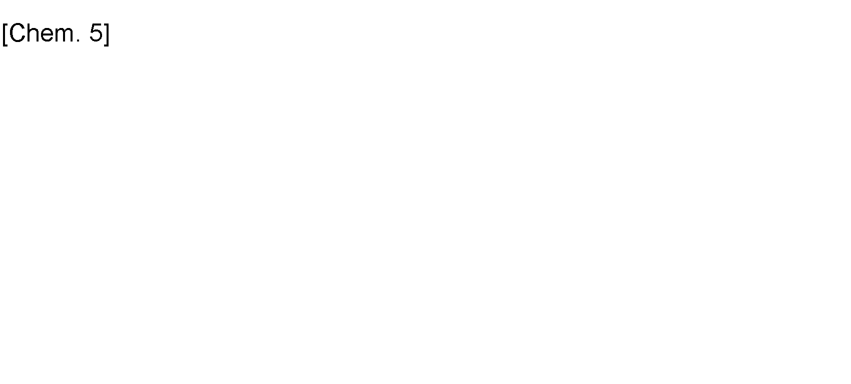 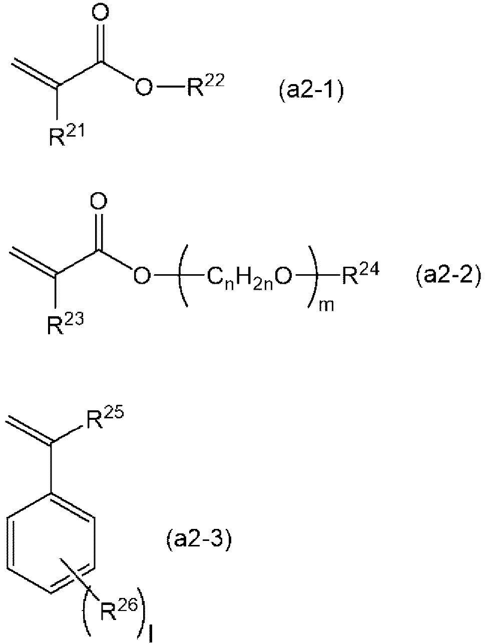 (In the formulae (a2-1), (a2-2) and (a2-3),
R²¹ is a hydrogen atom or a methyl group,
R²² is an alkyl group having from 1 to 18 carbon atoms,
R²³ is a hydrogen atom or a methyl group,
R²⁴ is a hydrogen atom or an alkyl group having from 1 to 18 carbon atoms,
R²⁵ is a hydrogen atom or a methyl group,
each R²⁶ independently represents an alkyl group having from 1 to 6 carbon atoms or an alkoxy group having from 1 to 6 carbon atoms,
n is an integer in a range of from 1 to 4, m is an integer in a range of from 1 to 200, and I is an integer in a range of from 0 to 5.)

In the formulae (a2-1), (a2-2) and (a2-3), each of R²¹, R²³, R²⁵ and R²⁷ is preferably a hydrogen atom.

The polymerizable monomer (a2) can be produced by a known method.

Alternatively, a commercially available product of the polymerizable monomer (a2) may be used. Examples of the commercially available products of the polymerizable monomer (a2) that has a group including a polyoxyalkylene chain and whose polymerizable unsaturated group is a (meth)acryloyl group include: "NK Ester M-20G", "NK Ester M-40G", "NK Ester M-90G","NK Ester M-230G", "NK Ester AM-90G", "NK Ester AMP-10G", "NK Ester AMP-20G", "NK Ester AMP-60G", which are manufactured by SHIN-NAKAMURA CHEMICAL Co., Ltd.; "BLEMMER PE-90", "BLEMMER PE-200", "BLEMMER PE-350", "BLEMMER PME-100", "BLEMMER PME-200", "BLEMMER PME-400", "BLEMMER PME-4000", "BLEMMER PP-1000", "BLEMMER PP-500", "BLEMMER PP-800", "BLEMMER 70PEP-350B", "BLEMMER 55PET-800", "BLEMMER 50POEP-800B", "BLEMMER 10PPB-500B", "BLEMMER NKH-5050", "BLEMMER AP-400", "BLEMMER AE-350", which are manufactured by NOF CORPORATION; and PLACCEL F series manufactured by Daicel Corporation.

The copolymer of the present invention may be constituted of two or more types of polymerizable monomers (a2) whose structures differ from each other. The polymerizable monomer (a2) is preferably a single type polymerizable monomer.

In the copolymer of the present invention, the content of the structural unit B with respect to the total of the structural units A and B is 20 mass% or more. In addition, the content is 50 mass% or less, preferably 40 mass% or less, and more preferably 35% or less.

The content of the structural unit B can be adjusted by the raw material feed ratio of the polymerizable monomer (a2) in producing the copolymer of the present invention.

The copolymer of the present invention only needs to contain the structural units A and B, and an additional polymerizable monomer other than the polymerizable monomer (a1) and the polymerizable monomer (a2) may be used as a reaction raw material to the extent that the effect of the present invention is not compromised.

The copolymer of the present invention is preferably a copolymer substantially composed of the structural units A and B, and more preferably a copolymer composed only of the structural units A and B. The wording "substantially composed of" herein means that the percentage content of the sum of the structural units A and B is 80 mass% or more, 90 mass% or more, 95 mass% or more, or 99 mass% or more in the copolymer of the present invention.

The copolymer of the present invention preferably contains no fluorine atom.

When the copolymer of the present invention is composed of the polymerizable monomer (a1) and the polymerizable monomer (a2), the copolymer of the present invention can be a copolymer containing no fluorine atom.

The weight average molecular weight (Mw) of the copolymer of the present invention is 10000 or more. The weight average molecular weight is preferably 15000 or more, and more preferably 20000 or more. In addition, the weight average molecular weight is preferably 500000 or less, more preferably 100000 or less, and still more preferably 40000 or less.

In the present invention, the weight average molecular weight (Mw) is a value based on gel permeation chromatography (GPC) measurement and a calibration of polystyrene standards. The value of the weight average molecular weight (Mw) is measured by the method described in Examples.

### [Method for Producing Random Copolymer]

The method for producing the random copolymer of the present invention is not particularly limited, and the random copolymer can be produced by a known method.

The copolymer of the present invention can be produced by a solution polymerization method, a bulk polymerization method, an emulsion polymerization method, or the like based on a polymerization mechanism such as radical polymerization process, cationic polymerization process, or anionic polymerization process. For example, when using a free radical polymerization method, a polymerizable monomer mixture is fed into an organic solvent and a general-purpose radical polymerization initiator is added thereto and thereby enabling to produce the copolymer of the present invention.

As the polymerization initiator, various polymerization initiators can be used, and examples thereof include: peroxides such as t-butylperoxy-2-ethylhexanoate, benzoyl peroxide, and diacyl peroxide; azo compounds such as azobisisobutyronitrile, dimethyl azobisisobutyrate, and phenylazotriphenylmethane; and metal chelate compounds such as Mn(acac)₃. **If** necessary, a chain transfer agent such as lauryl mercaptan, 2-mercaptoethanol, ethylthioglycolic acid, or octylthioglycolic acid, or a thiol compound having a coupling group such as γ-mercaptopropyltrimethoxysilane may be used as an additive such as a chain transfer agent.

Examples of the organic solvent include: alcohols such as ethanol, isopropyl alcohol, n-butanol, iso-butanol, and tert-butanol; ketones such as acetone, methyl ethyl ketone, methyl isobutyl ketone, and methyl amyl ketone; esters such as methyl acetate, ethyl acetate, butyl acetate, methyl lactate, ethyl lactate, and butyl lactate; monocarboxylic acid esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, and butyl 2-methoxypropionate; polar solvents such as dimethylformamide, dimethyl sulfoxide, and N-methylpyrrolidone; ethers such as methyl cellosolve, cellosolve, butyl cellosolve, butyl carbitol, and ethyl cellosolve acetate; propylene glycols such as propylene glycol, propylene glycol monomethyl ether, and propylene glycol monomethyl ether acetate, propylene glycol monoethyl ether acetate and propylene glycol monobutyl ether acetate, and esters thereof; halogen-based solvents such as 1,1,1-trichloroethane and chloroform; ethers such as tetrahydrofuran and dioxane; aromatics such as benzene, toluene and xylene; and fluorinated inert liquids such as perfluorooctane and perfluorotri-n-butylamine.

These solvents may be used singly, or two or more types thereof may be used in combination.

The feed ratio (mass) of the polymerizable monomer (a1) and the polymerizable monomer (a2) in producing the copolymer of the present invention is, for example, polymerizable monomer (a1):polymerizable monomer (a2) = 50:50 to 80:20, preferably polymerizable monomer (a1):polymerizable monomer (a2) = 60:40 to 80:20, and more preferably polymerizable monomer (a1):polymerizable monomer (a2) = 65:35 to 80:20. The polymerization temperature in the free radical polymerization is preferably in a range of from room temperature to 120°C.

The copolymer of the present invention can also be produced by living polymerization such as living radical polymerization or living anion polymerization of the polymerization component (living random copolymer).

In the living radical polymerization, a dormant species whose active polymerization terminal is protected by an atom or an atomic group reversibly generates a radical and reacts with a monomer, thereby a growth reaction proceeds, and the growth terminal does not lose activity even when the first monomer is consumed, and can react with a second monomer added sequentially and thereby affording a block polymer. Examples of such living radical polymerization include atom transfer radical polymerization (ATRP), reversible addition-fragmentation chain transfer polymerization (RAFT), nitroxide-mediated radical polymerization (NMP), and organotellurium-mediated radical polymerization (TERP). Among these methods, there is no particular restriction on which method to be used, but ATRP is preferable in terms of ease of control and the like. ATRP is a process that involves polymerization in which an organic halide, a sulfonyl halide compound, or the like is used as a polymerization initiator and a metal complex composed of a transition metal compound and a ligand is used as a catalyst.

Specific examples of the polymerization initiator that can be used in ATRP include 1-phenylethyl chloride, 1-phenylethyl bromide, chloroform, carbon tetrachloride, 2-chloropropionitrile, α,α'-dichloroxylene, α,α'-dibromoxylene, hexakis(α-bromomethyl)benzene, and alkyl esters having from 1 to 6 carbon atoms of 2-halogenated carboxylic acids having from 1 to 6 carbon atoms (such as 2-chloropropionic acid, 2-bromopropionic acid, 2-chloroisobutyric acid, 2-bromoisobutyric acid, etc.).

More specific examples of the alkyl ester having from 1 to 6 carbon atoms of 2-halogenated carboxylic acid having from 1 to 6 carbon atoms include methyl 2-chloropropionate, ethyl 2-chloropropionate, methyl 2-bromopropionate, and ethyl 2-bromoisobutyrate.

The transition metal compound that can be used in ATRP is represented by Mⁿ⁺Xₙ.

The transition metal Mⁿ⁺ of the transition metal compound represented by Mⁿ⁺Xₙ can be selected from the group consisting of Cu⁺, Cu²⁺, Fe²⁺, Fe³⁺, Ru²⁺, Ru³⁺, Cr²⁺, Cr³⁺, Mo⁰, Mo⁺, Mo²⁺, Mo³⁺, W²⁺, W³⁺, Rh³⁺, Rh⁴⁺, Co⁺, Co²⁺, Re²⁺, Re³⁺, Ni⁰, Ni⁺, Mn³⁺, Mn⁴⁺, V²⁺, V³⁺, Zn⁺, Zn²⁺, Au⁺, Au²⁺, Ag⁺, and Ag²⁺.

X of the transition metal compound represented by Mⁿ⁺Xₙ can be selected from the group consisting of a halogen atom, an alkoxyl group having from 1 to 6 carbon atoms, (SO₄)_{1/2}, (PO₄)_{1/3}, (HPO₄)_{1/2}, (H₂PO₄), triflate, hexafluorophosphate, methanesulfonate, aryl sulfonate (preferably benzenesulfonate or toluenesulfonate), SeR¹¹, CN and R¹²COO. Here, R¹¹ represents an aryl group, a linear or branched alkyl group having from 1 to 20 carbon atoms (preferably from 1 to 10 carbon atoms), and R¹² represents a hydrogen atom, or a linear or branched alkyl group having from 1 to 6 carbon atoms (preferably a methyl group) which may be substituted with 1 to 5 halogen atoms (preferably 1 to 3 fluorine atoms or chlorine atoms).

n of the transition metal compound represented by Mⁿ⁺Xₙ represents a formal charge on the metal, and is an integer of from 0 to 7.

Examples of a ligand compound capable of coordinate-bonding to the transition metal of the above-mentioned transition metal compound include: a compound having a ligand containing one or more nitrogen atoms, oxygen atoms, phosphorus atoms, or sulfur atoms that are capable of coordinating to the transition metal via a σ bond; a compound having a ligand containing two or more carbon atoms that are capable of coordinating to the transition metal via a π bond; and a compound having a ligand that is capable of coordinating to the transition metal via a µ bond or an η bond.

The above-mentioned transition metal complex is not particularly limited, and preferred examples thereof include transition metal complexes of Groups 7, 8, 9, 10, and 11, and further preferred examples thereof include complexes of zerovalent copper, monovalent copper, divalent ruthenium, divalent iron, or divalent nickel.

Specific examples of the catalyst that can be used in ATRP, when the central metal is copper, include complexes with ligands such as 2,2'-bipyridyl and derivatives thereof, 1,10-phenanthroline and derivatives thereof, and polyamines such as tetramethylethylenediamine, pentamethyldiethylenetriamine, and hexamethyltris(2-aminoethyl)amine. Examples of the divalent ruthenium complex include dichlorotris(triphenylphosphine)ruthenium, dichlorotris(tributylphosphine)ruthenium, dichloro(cyclooctadiene)ruthenium, dichloro(benzene)ruthenium, dichloro(p-cymene)ruthenium, dichloro(norbornadiene)ruthenium, cis-dichlorobis(2,2'-bipyridine)ruthenium, dichlorotris(1,10-phenanthroline)ruthenium, and carbonylchlorohydridetris(triphenylphosphine)ruthenium. Furthermore, examples of the divalent iron complex include bis(triphenylphosphine) complexes and triazacyclononane complexes.

A solvent is preferably used in living radical polymerization.

Examples of the solvent used in living radical polymerization include: ester solvents such as ethyl acetate, butyl acetate, and propylene glycol monomethyl ether acetate; ether solvent such as diisopropyl ether, dimethoxyethane, and diethylene glycol dimethyl ether; halogen-based solvents such as dichloromethane and dichloroethane; aromatic solvents such as toluene and xylene; ketone solvents such as methyl ethyl ketone, methyl isobutyl ketone, and cyclohexanone; alcohol solvents such as methanol, ethanol, or isopropanol; aprotic polar solvents such as dimethylformamide and dimethylsulfoxide.

The above-mentioned solvents may be used singly, or two or more types thereof may be used in combination.

As the feed ratio of the polymerizable monomer, the same feed ratio as the feed ratio in the free radical polymerization method described above can be employed.

The polymerization temperature in the living radical polymerization is preferably in a range of from room temperature to 120°C.

When the copolymer of the present invention is produced by living radical polymerization, there may be a case where a metal derived from the transition metal compound used in the polymerization remains in the resulting polymer. After completion of the polymerization, the metal remaining in the resulting polymer is preferably removed by using active alumina or the like.

### [Coating Composition]

The copolymer of the present invention can be suitably used as a leveling agent for a coating composition, and the coating composition of the present invention contains the copolymer of the present invention. The copolymer of the present invention can be used as a fluorine atom-free leveling agent that contains no fluorine atom, and hence is a leveling agent with low environmental impact and low accumulation in the environment.

The content of the copolymer of the present invention contained in the coating composition of the present invention varies depending on the type of base resin, the coating method, the intended film thickness, and the like, but is preferably within a range of from 0.0001 to 10 parts by mass, more preferably within a range of from 0.001 to 5 parts by mass, and still more preferably within a range of from 0.01 to 2 parts by mass per 100 parts by mass of the solid content of the coating composition. When the content of the copolymer of the present invention is within this range, the surface tension can be sufficiently reduced, intended leveling properties can be provided, and the occurrence of problems of foaming during coating and the like can be suppressed.

The intended use of the coating composition of the present invention is not particularly limited, and the coating composition can be used in any intended use where leveling properties are required. Examples thereof include coating compositions for displays such as color filters (color resists) and polarizing plate hard coats.

The coating composition of the present invention can be used as, for example, various coating material compositions and photosensitive resin compositions.

When the coating composition of the present invention is used as a composition for coating material, examples of the composition for coating material include: coating materials using a natural resin, such as a petroleum resin coating material, a shellac coating material, a rosin-based coating material, a cellulose-based coating material, a rubber-based coating material, an urushi lacquer coating material, a cashew lacquer coating material, and an oil-based vehicle coating material; and coating materials using a synthetic resin, such as a phenol resin coating material, an alkyd resin coating material, an unsaturated polyester resin coating material, an amino resin coating material, an epoxy resin coating material, a vinyl resin coating material, an acrylic resin coating material, a polyurethane resin coating material, a silicone resin coating material, and a fluororesin coating material.

The copolymer of the present invention is added to the above-mentioned composition for coating material, with a different base resin, thereby enabling to impart smoothness to the resulting coating film.

Into the composition for coating material can be appropriately added various additives if needed, and examples thereof include: colorants such as pigments, dyes, and carbon; inorganic powders such as silica, titanium oxide, zinc oxide, aluminum oxide, zirconium oxide, calcium oxide, and calcium carbonate; organic fine powders such as higher fatty acids, polyacrylic resins, and polyethylene; light resistance improvers, weather resistance improvers, heat resistance improvers, antioxidants, thickeners, and anti-settling agents.

As a method for applying the composition for coating material, any publicly known and used coating method can be used, and examples thereof include methods such as roll coater, electrostatic coating, bar coater, gravure coater, knife coater, dipping coating, and spray coating.

The photosensitive resin composition is a composition in which the resin changes its physical properties such as solubility, viscosity, transparency, refractive index, conductivity, and ion permeability upon irradiation with light such as visible light and ultraviolet light.

Among photosensitive resin compositions, a resist composition (such as a photoresist composition and a color resist composition for a color filter) is required to have high leveling properties. The resist composition is usually applied by spin coating so as to have a thickness of about from 1 to 2 µm onto a silicon wafer or a glass substrate on which various metals are vapor-deposited. During this application, if the applied film thickness fluctuates or heterogeneity in application occurs, the linearity and reproducibility of patterns deteriorate, and a resist pattern having intended accuracy cannot be provided. Moreover, besides these issues, there are also various issues related to leveling, such as a drop mark, overall heterogeneity, and a bead phenomenon in which the applied film on the edge area has a larger thickness than on the central area.

The coating composition of the present invention exhibits high leveling properties and can form a uniform coating film (a cured product), and therefore the above-mentioned issues can be solved when the coating composition of the present invention is used as a resist composition.

When the coating composition of the present invention is used as a photoresist composition, the photoresist composition contains an alkali-soluble resin, a radiation-sensitive substance (photosensitive substance), a solvent and the like, besides the copolymer of the present invention.

The alkali-soluble resin contained in the photoresist composition is a resin soluble in an alkaline solution that is a developer used when a resist is patterned.

Examples of the alkali-soluble resin include: novolak resins produced by condensing an aromatic hydroxy compound derivative such as phenol, cresol, xylenol, resorcinol, phloroglucinol or hydroquinone with an aldehyde compound such as formaldehyde, acetaldehyde or benzaldehyde; polymers or copolymers of vinylphenol compound derivatives such as o-vinylphenol, m-vinylphenol, p-vinylphenol or α-methylvinylphenol; (meth)acrylic polymers or copolymers such as acrylic acid, methacrylic acid or hydroxyethyl (meth)acrylate; polyvinyl alcohol; modified resins having a radiation-sensitive group such as a quinone diazide group, a naphthoquinone azide group, an aromatic azide group or an aromatic cinnamoyl group introduced via some of hydroxyl groups of these various resins; and urethane resins containing an acidic group such as a carboxylic acid or a sulfonic acid in the molecule.

These alkali-soluble resins may be used singly, or two or more types thereof may be used in combination.

The radiation-sensitive substance contained in the photoresist composition is a substance that changes the solubility of the alkali-soluble resin with respect to a developer upon irradiation with energy rays such as ultraviolet rays, far ultraviolet rays, excimer laser beams, X-rays, electron beams, ion beams, molecular beams, and γ-rays.

Examples of the radiation-sensitive substance include quinone diazide compounds, diazo compounds, azide compounds, onium salt compounds, halogenated organic compounds, mixtures of halogenated organic compounds and organometallic compounds, organic acid ester compounds, organic acid amide compounds, organic acid imide compounds, and poly(olefin sulfone) compounds.

Examples of the quinone diazide compound include sulfonic acid chlorides of quinone diazide derivatives such as 1,2-benzoquinone azide-4-sulfonic acid ester, 1,2-naphthoquinone diazide-4-sulfonic acid ester, 1,2-naphthoquinone diazide-5-sulfonic acid ester, 2,1-naphthoquinone diazide-4-sulfonic acid ester, 2,1-naphthoquinone diazide-5-sulfonic acid ester, other 1,2-benzoquinone azide-4-sulfonic acid chloride, 1,2-naphthoquinone diazide-4-sulfonic acid chloride, 1,2-naphthoquinone diazide-5-sulfonic acid chloride, 2,1-naphthoquinone diazide-4-sulfonic acid chloride, and 2,1-naphthoquinone diazide-5-sulfonic acid chloride.

Examples of the diazo compound include: salts of condensation products of p-diazodiphenylamine with formaldehyde or acetaldehyde; inorganic salts of diazoresins that are reaction products of the above-mentioned condensation products with hexafluorophosphate, tetrafluoroborate, perchlorate or periodate; and organic salts of diazoresins that are reaction products of the above-mentioned condensation products with sulfonic acids as described in US 3300309.

Examples of the azide compound include azidochalconic acid, diazidobenzalmethylcyclohexanones, azidocinnamylidene-acetophenones, aromatic azide compounds, and aromatic diazide compounds.

Examples of the halogenated organic compound include halogen-containing oxadiazole compounds, halogen-containing triazine compounds, halogen-containing acetophenone compounds, halogen-containing benzophenone compounds, halogen-containing sulfoxide compounds, halogen-containing sulfone compounds, halogen-containing thiazole compounds, halogen-containing oxazole compounds, halogen-containing triazole compounds, halogen-containing 2-pyrone compounds, halogen-containing aliphatic hydrocarbon compounds, halogen-containing aromatic hydrocarbon compounds, halogen-containing heterocyclic compounds, and sulfenyl halide compounds.

Besides the above-mentioned compounds, examples of the halogenated organic compounds include: compounds used as halogen-based flame retardants such as tris(2,3-dibromopropyl)phosphate, tris(2,3-dibromo-3-chloropropyl)phosphate, chlorotetrabromomethane, hexachlorobenzene, hexabromobenzene, hexabromocyclododecane, hexabromobiphenyl, tribromophenyl allyl ether, tetrachlorobisphenol A, tetrabromobisphenol A, bis(bromoethyl ether) tetrabromobisphenol A, bis(chloroethyl ether) tetrachlorobisphenol A, tris(2,3-dibromopropyl) isocyanurate, 2,2-bis (4-hydroxy-3,5-dibromophenyl) propane, and 2,2-bis(4-hydroxyethoxy-3,5-dibromophenyl) propane; and compounds used as organic chloro-based agricultural chemicals such as dichlorophenyltrichloroethane.

Examples of the organic acid ester include carboxylic acid esters and sulfonic acid esters. Examples of the organic acid amide include carboxylic acid amides and sulfonic acid amides. Examples of the organic acid imide include carboxylic acid imides and sulfonic acid imides.

The radiation-sensitive substances may be used singly, or two or more types thereof may be used in combination.

In the photoresist composition, the content of the radiation-sensitive substance is preferably in a range of from 10 to 200 parts by mass, and more preferably in a range of from 50 to 150 parts by mass per 100 parts by mass of the alkali-soluble resin.

Examples of the solvent for the photoresist composition include: ketones such as acetone, methyl ethyl ketone, cyclohexanone, cyclopentanone, cycloheptanone, 2-heptanone, methyl isobutyl ketone, and butyrolactone; alcohols such as methanol, ethanol, n-propyl alcohol, iso-propyl alcohol, n-butyl alcohol, iso-butyl alcohol, tert-butyl alcohol, pentanol, heptanol, octanol, nonanol, and decanol; ethers such as ethylene glycol dimethyl ether, ethylene glycol diethyl ether and dioxane; alcohol ethers such as ethylene glycol monomethyl ether, ethylene glycol monoethyl ether, ethylene glycol monopropyl ether, propylene glycol monomethyl ether, propylene glycol monoethyl ether and propylene glycol monopropyl ether; esters such as ethyl formate, propyl formate, butyl formate, methyl acetate, ethyl acetate, butyl acetate, propyl acetate, methyl propionate, ethyl propionate, propyl propionate, butyl propionate, methyl butyrate, ethyl butyrate, butyl butyrate, propyl butyrate, ethyl lactate, and butyl lactate; and monocarboxylic acid esters such as methyl 2-oxypropionate, ethyl 2-oxypropionate, propyl 2-oxypropionate, butyl 2-methoxypropionate, methyl 2-methoxypropionate, ethyl 2-methoxypropionate, propyl 2-methoxypropionate, and butyl 2-methoxypropionate; cellosolve esters such as cellosolve acetate, methyl cellosolve acetate, ethyl cellosolve acetate, propyl cellosolve acetate, and butyl cellosolve acetate; propylene glycols such as propylene glycol, propylene glycol monomethyl ether, propylene glycol monomethyl ether acetate, propylene glycol monoethyl ether acetate, and propylene glycol monobutyl ether acetate; diethylene glycols such as diethylene glycol monomethyl ether, diethylene glycol monoethyl ether, diethylene glycol dimethyl ether, diethylene glycol diethyl ether and diethylene glycol methyl ethyl ether; halogenated hydrocarbons such as trichloroethylene, chlorofluorocarbon solvent, HCFC, and HFC; completely fluorinated solvents such as perfluorooctane, aromatics such as toluene and xylene; and polar solvents such as dimethylacetamide, dimethylformamide, N-methylacetamide, and N-methylpyrrolidone.

These solvents may be used singly, or two or more types thereof may be used in combination.

When the coating composition of the present invention is used as a color resist composition, the color resist composition contains an alkali-soluble resin, a polymerizable compound, a colorant, and the like, besides the copolymer of the present invention.

As the alkali-soluble resin contained in color resists, the same alkali-soluble resin as the alkali-soluble resin contained in the photoresist composition described above can be used.

The polymerizable compound contained in the color resist composition is, for example, a compound having a photopolymerizable functional group capable of undergoing polymerization or crosslinking reaction upon irradiation with active energy rays such as ultraviolet rays.

Examples of the above-mentioned polymerizable compound include: unsaturated carboxylic acids such as (meth)acrylic acid; esters of a monohydroxy compound and an unsaturated carboxylic acid; esters of an aliphatic polyhydroxy compound and an unsaturated carboxylic acid; esters of an aromatic polyhydroxy compound and an unsaturated carboxylic acid; esters produced by an esterification reaction of an unsaturated carboxylic acid with a polyhydric carboxylic acid and a polyhydroxy compound such as the aliphatic polyhydroxy compound described above or an aromatic polyhydroxy compound; polymerizable compounds having a urethane skeleton produced by reacting a polyisocyanate compound with a (meth)acryloyl group-containing hydroxy compound; and polymerizable compounds having an acid group.

The polymerizable compounds may be used singly, or two or more types thereof may be used in combination.

Examples of the ester of an aliphatic polyhydroxy compound and an unsaturated carboxylic acid include (meth)acrylic acid esters such as ethylene glycol di(meth)acrylate, triethylene glycol di(meth)acrylate, trimethylolpropane tri(meth)acrylate, trimethylolethane tri(meth)acrylate, pentaerythritol di(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, and glycerol (meth)acrylate.

Examples thereof also include esters in which the (meth)acrylic acid moiety of these acrylates is changed to itaconic acid, crotonic acid, and maleic acid, those are itaconic acid esters, crotonic acid esters, and maleic acid esters, respectively.

Examples of the ester of an aromatic polyhydroxy compound and an unsaturated carboxylic acid include hydroquinone di(meth)acrylate, resorcinol di(meth)acrylate, and pyrogallol tri(meth)acrylate.

The ester produced by esterification reaction of an unsaturated carboxylic acid, a polyhydric carboxylic acid, and a polyhydroxy compound may be a single type compound or a mixture. Examples of such esters include: esters produced from (meth)acrylic acid, phthalic acid, and ethylene glycol; esters produced from (meth)acrylic acid, maleic acid, and diethylene glycol; esters produced from (meth)acrylic acid, terephthalic acid, and pentaerythritol; and esters produced from (meth)acrylic acid, adipic acid, butanediol, and glycerin.

Examples of the polymerizable compound having a urethane skeleton produced by reacting the polyisocyanate compound with a (meth)acryloyl group-containing hydroxy compound include: aliphatic diisocyanates such as hexamethylene diisocyanate and trimethylhexamethylene diisocyanate; cycloaliphatic diisocyanate such as cyclohexane diisocyanate and isophorone diisocyanate; and reaction products of an aromatic diisocyanate such as tolylene diisocyanate or diphenylmethane diisocyanate with a hydroxy compound having a (meth)acryloyl group such as 2-hydroxyethyl (meth)acrylate or 3-hydroxy[1,1,1-tri(meth)acryloyloxymethyl]propane.

The polymerizable compound having an acid group is, for example, an ester of an aliphatic polyhydroxy compound and an unsaturated carboxylic acid, and is preferably a polyfunctional polymerizable compound having an acid group produced by reacting an unreacted hydroxyl group of an aliphatic polyhydroxy compound with a non-aromatic carboxylic acid anhydride. The aliphatic polyhydroxy compound used in the preparation of the polyfunctional polymerizable compound is preferably pentaerythritol or dipentaerythritol.

In terms of improvement of developability, curability, and the like, the polyfunctional polymerizable compound has an acid value preferably in the range of from 0.1 to 40, and more preferably in the range of from 5 to 30. When two or more polyfunctional polymerizable compounds having an acid group are used in combination, or when a polyfunctional polymerizable compound having an acid group and a polyfunctional polymerizable compound having no acid group are used in combination, the mixture of the polymerizable compounds is preferably adjusted to have an acid value within the range mentioned above.

As a specific example of the polymerizable compound having an acid group, mention may be made of a mixture whose main components are succinic ester of dipentaerythritol pentaacrylate, dipentaerythritol hexaacrylate, and dipentaerythritol pentaacrylate, and this mixture is commercially available as ARONIX TO-1382 (manufactured by TOAGOSEI CO., LTD.).

Besides the above-mentioned compounds, examples of polymerizable compounds include: (meth)acrylamides such as ethylenebis(meth)acrylamide; allyl esters such as diallyl phthalate; and compounds having a vinyl group such as divinyl phthalate.

In the color resist composition, the content of the polymerizable compound is preferably in the range of from 5 to 80 mass%, more preferably in the range of from 10 to 70 mass%, and still more preferably in the range of from 20 to 50 mass% with respect to a total solid content of the color resist composition.

The colorant of the color resist composition is not particularly limited as long as it is capable of coloring, and may be, for example, a pigment or a dye. As the pigment, either an organic pigment or an inorganic pigment may be used. As the organic pigment, there can be used pigments of various hues such as a red pigment, a green pigment, a blue pigment, a yellow pigment, a purple pigment, an orange pigment, and a brown pigment. Moreover, examples of the chemical structure of the organic pigment include azo type, phthalocyanine type, quinacridone type, benzimidazolone type, isoindolinone type, dioxazine type, indanthrene type, and perylene type. Furthermore, examples of the inorganic pigment include barium sulfate, lead sulfate, titanium oxide, yellow lead, red iron oxide, and chromium oxide.

Note that the following "C.I." means a color index.

Examples of the red pigment include C.I. Pigment Red 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, 276, and the like. Among them, C.I. Pigment Red 48:1, 122, 168, 177, 202, 206, 207, 209, 224, 242, or 254 is preferable, and C.I. Pigment Red 177, 209, 224, or 254 is more preferable.

Examples of the green pigment include C.I. Pigment Green 1, 2, 4, 7, 8, 10, 13, 14, 15, 17, 18, 19, 26, 36, 45, 48, 50, 51, 54, 55, and 58. Among them, C.I. Pigment Green 7, 36 or 58 is preferable.

Examples of the blue pigment include C.I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, and 79. Among them, C.I. Pigment Blue 15, 15:1, 15:2, 15:3, 15:4, or 15:6 is preferable, and C.I. Pigment Blue 15:6 is more preferable.

Examples of the yellow pigment include C.I. Pigment Yellow 1, 1:1, 2, 3, 4, 5, 6, 9, 10, 12, 13, 14, 16, 17, 24, 31,32, 34, 35, 35:1, 36, 36:1, 37, 37:1, 40, 41, 42, 43, 48, 53, 55, 61, 62, 62:1, 63, 65, 73, 74, 75, 81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, and 208. Among them, C.I. Pigment Yellow 83, 117, 129, 138, 139, 150, 154, 155, 180, or 185 is preferable, and C.I. Pigment Yellow 83, 138, 139, 150, or 180 is more preferable.

Examples of the purple pigment include C.I. Pigment Violet 1, 1:1, 2, 2:2, 3, 3:1, 3:3, 5, 5:1, 14, 15, 16, 19, 23, 25, 27, 29, 31, 32, 37, 39, 42, 44, 47, 49, and 50. Among them, C.I. Pigment Violet 19 or 23 is preferable, and C.I. Pigment Violet 23 is more preferable.

Examples of the orange pigment include C.I. Pigment Orange 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, and 79. Among them, C.I. Pigment Orange 38 or 71 is preferable.

Since each pixel of color filters used in liquid crystal display devices and in organic EL display devices has the three primary colors of red (R), green (G), and blue (B), the red pigment, the green pigment, and the blue pigment are used as main components, and organic pigments of colors such as yellow, purple, and orange may be used as hue adjustment for the purpose of improving color reproducibility.

The average particle size of the organic pigment is preferably 1 µm or less, more preferably 0.5 µm or less, still more preferably 0.3 µm or less in order to increase the luminance of color liquid crystal display devices and organic EL display devices. The organic pigments are preferably used after dispersion treatment so as to have such an average particle size.

The average primary particle size of the organic pigments is preferably 100 nm or less, more preferably 50 nm or less, still more preferably 40 nm or less, and particularly preferably in the range of from 10 to 30 nm.

Note that, the average particle size of the organic pigments is measured by a dynamic light scattering type particle size analyzer, and can be measured by, for example, Nanotrac particle size analyzer "UPA-EX150" or "UPA-EX250" available from NIKKISO CO., LTD.

The colorant when the color resist composition is used for forming the black matrix (BM) is not particularly limited as long as it is black in color, and examples thereof include carbon black, lamp black, acetylene black, bone black, thermal black, channel black, furnace black, graphite, black iron oxide, and titanium black. Among them, carbon black and titanium black are preferable in terms of light shielding ratios and image characteristics.

Alternatively, there may be used a combination of two or more types of organic pigments mixed to create black by color mixing.

Examples of commercially available products of the carbon black include: MA7, MA8, MA11, MA100, MA100R, MA220, MA230, MA600, #5, #10, #20, #25, #30, #32, #33, #40, #44, #45, #47, #50, #52, #55, #650, #750, #850, #950, #960, #970, #980, #990, #1000, #2200, #2300, #2350, #2400, #2600, #3050, #3150, #3250, #3600, #3750, #3950, #4000, #4010, OIL7B, OIL9B, OIL11B, OIL30B, OIL31B, etc., which are manufactured by Mitsubishi Chemical Corporation; Printex3, Printex3OP, Printex30, Printex30OP, Printex40, Printex45, Printex55, Printex60, Printex75, Printex80, Printex85, Printex90, Printex A, Printex L, Printex G, Printex P, Printex U, Printex V, Printex G, SpecialBlack550, SpecialBlack350, SpecialBlack250, SpecialBlack100, SpecialBlack6, SpecialBlack5, SpecialBlack4, Color Black FW1, Color Black FW2, Color Black FW2V, Color Black FW18, Color Black FW18, Color Black FW200, Color Black S160, Color Black S170, etc., which are manufactured by Evonik Degussa Japan Ltd; Monarch120, Monarch280, Monarch460, Monarch800, Monarch880, Monarch900, Monarch1000, Monarch1100, Monarch1300, Monarch1400, Monarch4630, REGAL99, REGAL99R, REGAL415, REGAL415R, REGAL250, REGAL250R, REGAL330, REGAL400R, REGAL55R0, REGAL660R, BLACK PEARLS480, PEARLS130, VULCAN XC72R, ELFTEX-8, etc., which are manufactured by Cabot Japan K.K; and RAVEN11, RAVEN14, RAVEN15, RAVEN16, RAVEN22 RAVEN30, RAVEN35, RAVEN40, RAVEN410, RAVEN420, RAVEN450, RAVEN500, RAVEN780, RAVEN850, RAVEN890H, RAVEN1000, RAVEN1020, RAVEN1040, RAVEN1060U, RAVEN1080U, RAVEN1170, RAVEN1190U, RAVEN1250, RAVEN1500, RAVEN2000, RAVEN2500U, RAVEN3500, RAVEN5000, RAVEN5250, RAVEN5750, RAVEN7000, etc., which are manufactured by Columbian Carbon Company.

Among the above-mentioned carbon blacks, resin-coated carbon black is preferable as a carbon black having high optical density and high surface resistivity required for a black matrix of a color filter.

Examples of commercially available products of the titanium black include titanium black 10S, 12S, 13R, 13M, and 13M-C manufactured by Mitsubishi Materials Corporation.

As a colorant used for forming the black matrix (BM), two or more types of organic pigments may be mixed to create black color by color mixing, and examples thereof include a black pigment produced by mixing pigments of three colors of red, green, and blue.

Examples of the coloring material that can be mixed and used for preparing the black pigment include Victoria Pure Blue (C.I. 42595), Auramine O (C.I. 41000), Cationic Brilliant Flavin (Basic 13), Rhodamine 6GCP (C.I. 45160), Rhodamine B (C.I. 45170), Safranin OK70:100 (C.I. 50240), Erioglaucin X (C.I. 42080), No. 120/Lionol Yellow (C.I. 21090), Lionol Yellow GRO (C.I. 21090), Symuler Fast Yellow 8GF (C.I. 21105), Benzidine Yellow 4T-564D (C.I. 21095), Symuler Fast Red 4015 (C.I. 12355), Lionol Red 7B4401 (C.I. 15850), Fastogen Blue TGR-L (C.I. 74160), Lionol Blue SM (C.I. 26150), Lionol Blue ES (C. I. Pigment Blue 15:6), Lionogen Red GD (C.I. Pigment Red 168), and Lionol Green 2YS (C.I. Pigment Green 36).

Examples of other coloring materials that can be mixed and used to prepare the black pigment include: C.I. Pigment Yellow 20, 24, 86, 93, 109, 110, 117, 125, 137, 138, 147, 148, 153, 154, and 166; C.I. Pigment Orange 36, 43, 51, 55, 59, and 61; C.I. Pigment Red 9, 97, 122, 123, 149, 168, 177, 180, 192, 215, 216, 217, 220, 223, 224, 226, 227, 228, and 240; C.I. Pigment Violet 19, 23, 29, 30, 37, 40, and 50; C.I. Pigment Blue 15, 15:1, 15:4, 22, 60, and 64; C.I. Pigment Green 7; and C.I. Pigment Brown 23, 25, and 26.

When carbon black is used as the black pigment, the average primary particle size of the carbon black is preferably in the range of from 0.01 to 0.08 µm, and more preferably in the range of from 0.02 to 0.05 µm in terms of excellent developability.

The particle shape of carbon black is different from that of organic pigments or the like, and carbon black is present in a state called a structure in which primary particles are fused to each other, and fine pores are formed on the particle surface by post-treatment in some cases. Therefore, generally, in order to represent the particle shape of carbon black, besides the average particle size of primary particles determined by the same method as that of the organic pigment, the DBP absorption number (JIS K6221) and the specific surface area (JIS K6217) by the BET method are preferably measured and used as indices of the structure and of the pore amount.

The amount of dibutylphthalic acid (hereinafter, abbreviated as "DBP") absorbed by carbon black is preferably in the range of from 40 to 100 cm³/100 g, and more preferably in the range of from 50 to 80 cm³/100 g in terms of excellent dispersibility and developability. The specific surface area of carbon black measured by the BET method is preferably in the range of from 50 to 120 m²/g, and more preferably in the range of from 60 to 95 m²/g in terms of excellent dispersion stability.

Examples of the dye as the colorant for the color resist composition include azo dyes, anthraquinone dyes, phthalocyanine dyes, quinoneimine dyes, quinoline dyes, nitro dyes, carbonyl dyes, and methine dyes.

Examples of the azo dyes include C.I. Acid Yellow 11, C.I. Acid Orange 7, C.I. Acid Red 37, C.I. Acid Red 180, C.I. Acid Blue 29, C.I. Direct Red 28, C.I. Direct Red 83, C.I. Direct Yellow 12, C.I. Direct Orange 26, C.I. Direct Green 28, C.I. Direct Green 59, C.I. Reactive Yellow 2, C.I. Reactive Red 17, C.I. Reactive Red 120, C.I. Reactive Black 5, C.I. Disperse Orange 5, C.I. Disperse Red 58, C.I. Disperse Blue 165, C.I. Basic Blue 41, C.I. Basic Red 18, C.I. Mordant Red 7, C.I. Mordant Yellow 5, C.I. and Mordant Black 7.

Examples of the anthraquinone dye include C.I. Vat Blue 4, C.I. Acid Blue 40, C.I. Acid Green 25, C.I. Reactive Blue 19, C.I. Reactive Blue 49, C.I. Disperse Red 60, C.I. Disperse Blue 56, and C.I. Disperse Blue 60.

Examples of the phthalocyanine dye include C.I. Pad Blue 5, examples of the quinoneimine dye include C.I. Basic Blue 3 and C.I. Basic Blue 9, examples of the quinoline dye include C.I. Solvent Yellow 33, C.I. Acid Yellow 3, and C.I. Disperse Yellow 64, and examples of the nitro dye include C.I. Acid Yellow 1, C.I. Acid Orange 3, and C.I. Disperse Yellow 42.

As the colorant of the color resist composition, a pigment is preferably used in terms that the resulting coating film is excellent in light resistance, weather resistance, and fastness properties, but a dye may be used in combination with the pigment as necessary in order to adjust the hue.

In the color resist composition, the content of the colorant is preferably 1 mass% or more, more preferably in the range of from 5 to 80 mass%, and still more preferably in the range of from 5 to 70 mass% with respect to the total solid content of the color resist composition.

When the color resist composition is used for forming each pixel of red (R), green (G), and blue (B) of a color filter, the content of the colorant in the color resist composition is preferably in the range of from 5 to 60 mass%, and more preferably in the range of from 10 to 50 mass% with respect to the total solid content of the color resist composition.

When the color resist composition is used for forming a black matrix of a color filter, the content of the colorant in the color resist composition is preferably in the range of from 20 to 80 mass%, and more preferably in the range of from 30 to 70 mass% with respect to the total solid content of the color resist composition.

When the pigment is used as a colorant in the color resist composition, the pigment is preferably used as a pigment dispersion liquid that is prepared by using a dispersant and thereby dispersing the pigment in an organic solvent. Examples of the dispersant include: surfactants; pigment intermediates or derivatives; dyestuff intermediates or derivatives; and resin-type dispersants such as polyamide resins, polyurethane resins, polyester resins, and acrylic resins. Among them, graft copolymers having a nitrogen atom, acrylic block copolymers having a nitrogen atom, urethane resin dispersants and the like are preferable. These dispersants have a nitrogen atom, the nitrogen atom has an affinity for the pigment surface, and the moiety other than the nitrogen atom increases the affinity for the medium, and thereby dispersion stability is enhanced.

These dispersants may be used singly, or two or more types thereof may be used in combination.

Examples of commercially available products of the dispersant include: "Efka" series ("Efka 46" etc.) manufactured by BASF SE; "Disperbyk" series and "BYK" series ("BYK-160", "BYK-161", "BYK-2001", etc.) manufactured by BYK Japan KK; "Solsperse" series manufactured by Lubrizol Japan Ltd.; "KP" series manufactured by Shin-Etsu Chemical Co., Ltd.; "POLYFLOW" series manufactured by Kyoeisha Chemical Co., Ltd.; "DISPARLON" Series manufactured by Kusumoto Chemicals, Ltd.; and "AJISPER" series ("AJISPER PB-814" etc.) manufactured by Ajinomoto Fine-Techno Co., Inc.

Examples of the organic solvent used in the preparation of the pigment dispersion liquid include: acetic acid ester-based solvents such as propylene glycol monomethyl ether acetate and propylene glycol monoethyl ether acetate; propionate-based solvents such as ethoxypropionate; aromatic solvents such as toluene, xylene, and methoxybenzene; ether-based solvent such as butyl cellosolve, propylene glycol monomethyl ether, diethylene glycol ethyl ether, and diethylene glycol dimethyl ether; ketone-based solvent such as methyl ethyl ketone, methyl isobutyl ketone, and cyclohexanone; aliphatic hydrocarbon-based solvents such as hexane; nitrogen compound-based solvent such as N,N-dimethylformamide, γ-butyrolactam, and N-methyl-2-pyrrolidone; lactone-based solvents such as γ-butyrolactone; and carbamic acid esters.

These solvents may be used singly, or two or more types thereof may be used in combination.

Examples of the method for preparing the pigment dispersion liquid include a method performing a colorant kneading and dispersion step and a fine dispersion step, and a method performing only fine dispersion step. In the kneading and dispersing step, a colorant, a part of an alkali-soluble resin, and the dispersant, if needed, are mixed and kneaded. Dispersion and at the same time applying strong shearing force by using a kneader can disperse the colorant.

Examples of the machine used for kneading include a two-roll machine, a three-roll machine, a ball mill, a tron mill, a disper, a kneader, a co-kneader, a homogenizer, a blender, and a single or twin-screw extruder.

Refining particle size of the colorant is preferably performed by salt milling method or the like before the above-described kneading is performed.

In the fine dispersion step, a mixture of the composition containing the colorant produced in the kneading and dispersing step and a solvent added thereto, or a mixture of the colorant, the alkali-soluble resin, the solvent, and the dispersant as necessary, is mixed and dispersed together with a dispersion medium for fine particles of glass, zirconia, or ceramic using a disperser, so that the particles of the colorant can be dispersed into a minute state close to the primary particles.

From the viewpoint of improving the transmittance, contrast, and the like of color filters, the average particle size of the primary particles of the colorant is preferably from 10 to 100 nm, and more preferably from 10 to 60 nm.

Note that, the average particle size of the colorant is measured by a dynamic light scattering type particle size analyzer, and can be measured by, for example, Nanotrac particle size analyzer "UPA-EX150" or "UPA-EX250" available from NIKKISO CO., LTD.

### EXAMPLES

Hereinafter, the present invention will be described in more detail with reference to specific examples. Note that, the weight average molecular weight (Mw) of the synthesized resin is measured under the following GPC measurement conditions.

### [GPC Measurement Conditions]

Measuring device: high speed GPC system "HLC-8420GPC" manufactured by Tosoh Corporation
Columns: "TSK GUARDCOLUMN SuperHZ-L" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation
Detector: RI (differential refractometer)
Data processing: "EcoSEC Data Analysis Version 1.07" manufactured by Tosoh Corporation
Column temperature: 40°C
Developing solvent: tetrahydrofuran
Flow rate: 0.35 mL/min
Measurement sample: 7.5 mg of a sample was dissolved in 10 mL of tetrahydrofuran, and the resultant solution was filtered through a microfilter to give a measurement sample.
Sample injection volume: 20 µL
Standard sample: The following monodispersed polystyrenes having known molecular weights were used in accordance with the measurement manual "HLC-8420GPC".

### (Monodisperse Polystyrene)

"A-300" manufactured by Tosoh Corporation
"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation
"F-288" manufactured by Tosoh Corporation

### Example 1

Into a glass flask equipped with a stirrer, a thermometer, a cooling tube, and a dropping device was fed 100.0 g of butyl acetate as a solvent, and the temperature was raised to 90°C while stirring it under a nitrogen stream. Subsequently, 67.0 g of 3-methacryloyloxypropyltris(trimethylsiloxy)silane (forming the structural unit A), 33.0 g of propylene glycol-polybutylene glycol-monomethacrylate (forming the structural unit B: BLEMMER 10PPB-500B manufactured by NOF CORPORATION), and 70.0 g of butyl acetate as a solvent were mixed to give a mixed liquid A. In addition, 3.0 g of an initiator (PERBUTYL O, manufactured by NOF CORPORATION) and 63.3 g of butyl acetate as a solvent were mixed to give a mixed liquid B.

The mixed liquids A and B were added dropwise to the glass flask at 90°C over 120 minutes. After completion of the dropwise addition, the mixture was stirred at 90°C for 5 hours, then heated to 110°C, and stirred for 1 hour. After completion of the reaction, the solvent was removed by distillation under reduced pressure to give a random copolymer (1).

As a result of analysis by GPC, the weight average molecular weight (Mw) was found to be 17000. From the raw material feed ratio, the content of the functional group represented by -Si[OSi(CH₃)₃]₃ in the random copolymer (1) was found to be 50 mass%.

### Comparative Example 1

Into a glass flask equipped with a stirrer, a thermometer, a cooling tube, and a dropping device was fed 100.0 g of butyl acetate as a solvent, and the temperature was raised to 90°C while stirring it under a nitrogen stream. Subsequently, 33.0 g of 3-methacryloyloxypropyltris(trimethylsiloxy)silane, 67.0 g of propylene glycol-polybutylene glycol-monomethacrylate, and 70.0 g of butyl acetate as a solvent were mixed to give a mixed liquid A. In addition, 3.0 g of an initiator (PERBUTYL O) and 63.3 g of butyl acetate as a solvent were mixed to give a mixed liquid B.

The mixed liquids A and B were added dropwise to the glass flask at 90°C over 120 minutes. After completion of the dropwise addition, the mixture was stirred at 90°C for 5 hours, then heated to 110°C, and stirred for 1 hour. After completion of the reaction, the solvent was removed by distillation under reduced pressure to give a random copolymer (2).

As a result of analysis by GPC, Mw was found to be 17000. Moreover, from the raw material feed ratio, the content of the functional group represented by -Si[OSi(CH₃)₃]₃ in the random copolymer (2) was found to be 24 mass%.

### Comparative Example 2

Into a flask purged with nitrogen were fed 75.0 g of methyl ethyl ketone as a solvent and 33.5 g of 3-methacryloyloxypropyltris(trimethylsiloxy)silane, and the temperature was raised to 50°C with stirring it under a nitrogen stream. Subsequently, 4.2 g of 2,2'-bipyridyl and 1.5 g of cuprous chloride were fed thereto, and the mixture was stirred for 30 minutes while the inside of the flask was maintained at 50°C. Thereafter, 2.7 g of ethyl 2-bromoisobutyrate was added thereto, and the mixture was allowed to react at 50°C for 4 hours under a nitrogen stream to give a polymer segment in which a moiety containing a trimethylsilyl group is contained.

Then, 16.5 g of propylene glycol-polybutylene glycol-monomethacrylate was added to the reaction system containing the polymer segment, and the mixture was allowed to react at 50°C for 20 hours to give a reaction product. Then, 30 g of activated alumina was added to the resultant reaction product, and the mixture was stirred. The activated alumina was filtered, and then the solvent was removed by distillation under reduced pressure to give a block copolymer (3).

The molecular weight of the block copolymer (3) was measured by GPC, and as a result, Mw was found to be 7100, Mn was 6100, and Mw/Mn was 1.2. Moreover, from the raw material feed ratio, the content of the functional group represented by -Si[OSi(CH₃)₃]₃ in the block copolymer (3) was found to be 50 mass%.

### [Film Formation and Evaluation of Coating Film]

### (1) Method for evaluating smoothness of coating film

A coating composition was produced by mixing 3.0 g of a 40 mass% resin solution (ACRYDIC ZL-295, manufactured by DIC Corporation) of an alkali-soluble resin; 1.2 g of ARONIX M-402 (manufactured by Toagosei Company, Limited; a mixture of dipentaerythritol pentaacrylate and dipentaerythritol hexaacrylate); the copolymer produced in Examples or Comparative Examples in an amount of 0.001 g in terms of solid content; and 3.8 g of PGMEA.

Onto the central area of a 10 cm × 10 cm chrome-plated glass substrate was dropped 3 mL of this composition, and spin coating was performed under the conditions of a rotation speed of 1000 rpm and a rotation time of 10 seconds, followed by heating and drying at 100°C for 100 seconds to prepare an article (laminate) having a coating film layer. The coating film layer was visually observed, and the smoothness of the coating film layer was evaluated according to the following criteria.
O: Almost no coating film heterogeneity is observed.
Δ : Coating film heterogeneity is partially observed.
× : A lot of coating film heterogeneity is observed.

### (2) Method for evaluating recoatability

To 3.0 g of a 40 mass% resin solution of an alkali-soluble resin and 1.2 g of ARONIX M-402 was added the copolymer produced in Example or Comparative Example in an amount of 1.0 mass% in terms of a solid content ratio. The mixture was diluted with PGMEA to prepare a solution having a resin solid concentration (NV) of 19.5%.

To the central area of a 7 cm × 7 cm glass substrate was added 1 mL of the prepared solution, and spin coating was performed at a rotation speed of 1000 rpm and a rotation time of 10 seconds, followed by heating and drying at 80°C for 3 minutes thereby evaporating the solvent.

Next, the dried coating film was cured by being irradiated with ultraviolet rays (UV) using an ultraviolet ray curing device (under air atmosphere, with a highpressure mercury lamp, and an ultraviolet ray irradiation amount of 0.5 kJ/m²). Thereafter, development was performed using a 0.5% KOH-based developer, and further heat treatment was performed at 230°C for 20 minutes to afford a cured film.

The contact angle of PGMEA on the surface of the cured film was measured with a contact angle meter ("MODEL CA-W701" manufactured by Kyowa Interface Science Co., Ltd). The small contact angle means that the recoatability of the cured film is good. The recoatability was evaluated based on the contact angle according to the following criteria.
O: The PGMEA contact angle is 20 degrees or less.
Δ : The PGMEA contact angle is more than 20 degrees and 30 degrees or less.
x : The PGMEA contact angle is more than 30 degrees.

**[Table 1]**

| | Example 1 | Comparative Example 1 | Comparative Example 2 |
|---|---|---|---|
| Type | Random copolymer | Random copolymer | Block copolymer |
| Structural unit A : Structural unit B (mass ratio) | 67:33 | 33:67 | 67:33 |
| Content of -Si-[O-Si(CH₃)₃]₃ group (mass%) | 50 | 24 | 50 |
| Leveling properties | ○ | × | ○ |
| Recoatability | ○ | ○ | × |

From Table 1, it can be confirmed that the films produced from the compositions using the random copolymers of Examples are excellent in both leveling properties and recoatability as compared with those of Comparative Examples.

## Claims

1. A random copolymer comprising:
a structural unit A derived from a polymerizable monomer (a1) including a functional group represented by -Si[OSi(R)₃]ₙ[R']₃₋ₙ (where n is an integer of from 1 to 3, each R independently represents an alkyl group having from 1 to 3 carbon atoms, and each R' independently represents an alkyl group having from 1 to 3 carbon atoms) and a (meth)acryloyl group;
a structural unit B derived from a polymerizable monomer (a2) including one or more selected from the group consisting of an alkyl group having from 1 to 18 carbon atoms, an aromatic group having from 6 to 18 carbon atoms, and a group containing a polyoxyalkylene chain,
wherein
the random copolymer contains the structural unit A in an amount of from 50 to 80 mass% with respect to a total of the structural units A and B, and
the random copolymer has a weight average molecular weight (Mw) of 10000 or more.

2. The random copolymer according to claim 1, which is produced by free radical polymerization of the polymerizable monomer (a1) and the polymerizable monomer (a2).

3. The random copolymer according to claim 1 or 2, wherein the random copolymer contains the functional group represented by -Si[OSi(R)₃]ₙ[R']₃₋ₙ of the structural unit A in an amount of more than 30 mass% and 60 mass% or less.

4. The random copolymer according to claim 1 to 3, wherein the polymerizable monomer (a1) is a compound represented by formula (a1-1) set forth below: 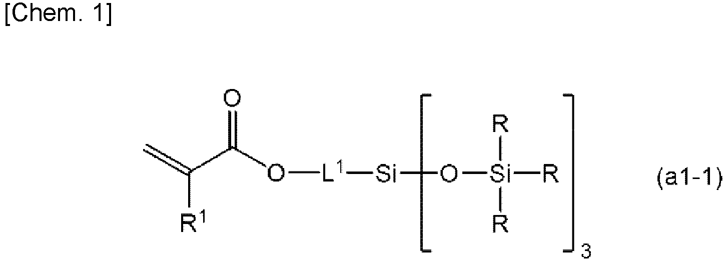 (where
each R independently represents an alkyl group having from 1 to 3 carbon atoms,
R¹ is a hydrogen atom or a methyl group, and
L¹ is a divalent organic group or a single bond).

5. The random copolymer according to any one of claims 1 to 4, wherein the functional group represented by -Si[OSi(R)₃]ₙ[R']₃₋ₙ is -Si [OSi(CH₃)₃]₃.

6. The random copolymer according to any one of claims 1 to 5, wherein the polymerizable monomer (a2) is a polymerizable monomer comprising an alkyl group having from 1 to 18 carbon atoms and/or a group containing a polyoxyalkylene chain.

7. The random copolymer according to any one of claims 1 to 6, wherein the polymerizable monomer (a2) is one or more selected from the group consisting of a compound represented by formula (a2-1) and a compound represented by formula (a2-2): 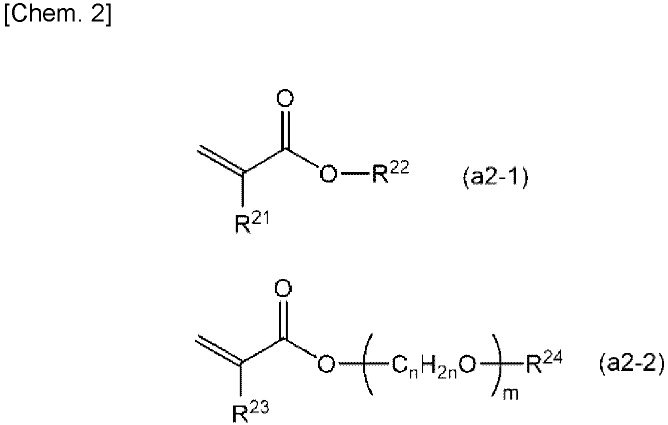 (where
R²¹ is a hydrogen atom or a methyl group,
R²² is an alkyl group having from 1 to 18 carbon atoms,
R²³ is a hydrogen atom or a methyl group,
R²⁴ is a hydrogen atom or an alkyl group having from 1 to 18 carbon atoms,
n is an integer in a range of from 1 to 4, and m is an integer in a range of from 1 to 200).

8. The random copolymer according to claim 7, wherein R²¹ and R²³ are each a hydrogen atom.

9. The random copolymer according to any one of claims 1 to 8, comprising no fluorine atom.

10. A coating composition, comprising the random copolymer described in any one of claims 1 to 9.

11. The coating composition according to claim 10, which is for a display.

12. A resist composition, comprising the random copolymer described in any one of claims 1 to 9.

13. An article, comprising the random copolymer described in any one of claims 1 to 9.

14. A method for producing a random copolymer, the method comprising free radical polymerization in which a compound represented by formula (a1-1), and any one or more of a compound represented by formula (a2-1) and a compound represented by formula (a2-2) are used as reaction raw materials: 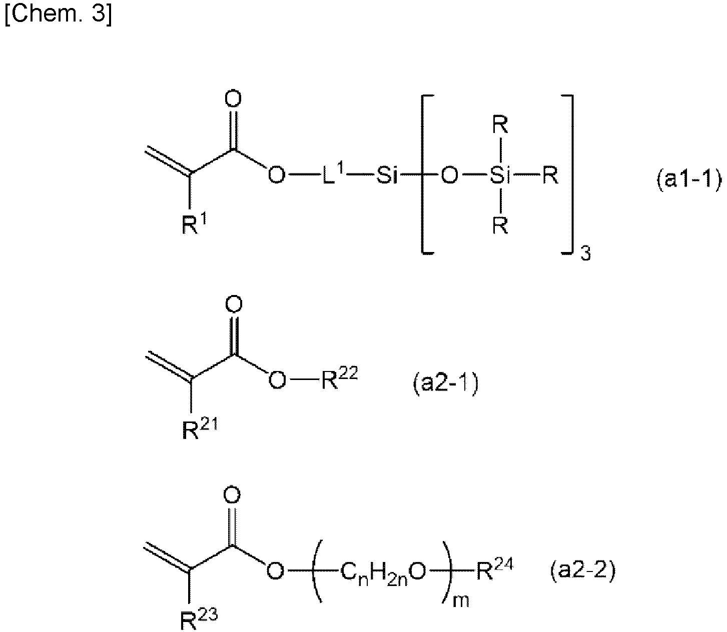 (where
each R independently represents an alkyl group having from 1 to 3 carbon atoms,
R¹ is a hydrogen atom or a methyl group,
L¹ is a divalent organic group or a single bond,
R²¹ is a hydrogen atom or a methyl group,
R²² is an alkyl group having from 1 to 18 carbon atoms,
R²³ is a hydrogen atom or a methyl group,
R²⁴ is a hydrogen atom or an alkyl group having from 1 to 18 carbon atoms,
n is an integer in a range of from 1 to 4, and m is an integer in a range of from 1 to 200).
